Europäisches Patentamt

European Patent Office

Office européen des brevets

(19)

(11) Publication number: **0 678 913 A1**

# EUROPEAN PATENT APPLICATION

(21) Application number: 95105667.0

(51) Int. Cl.⁶: **H01L 21/768**, H01L 23/532

(22) Date of filing: **13.04.95**

(30) Priority: **15.04.94 JP 76875/94**

(43) Date of publication of application:
**25.10.95 Bulletin 95/43**

(84) Designated Contracting States:
**DE GB**

(71) Applicant: **MATSUSHITA ELECTRIC
INDUSTRIAL CO., LTD.**
**1006, Ohaza Kadoma**
**Kadoma-shi,**
**Osaka 571 (JP)**

(72) Inventor: **Yano, Kousaku**
**4-7-5, Hoshidanishi**
**Katano-shi, Osaka 576 (JP)**
Inventor: **Sugiyama, Tatsuo**
**1-10-8, Shiginoshi,**

**Joto-ku**
**Osaka-shi,**
**Osaka 536 (JP)**
Inventor: **Ueda, Satoshi**
**7-4-2, Kourigaoka**
**Hirakata-shi,**
**Osaka 573 (JP)**
Inventor: **Nomura, Noboru**
**35, Fukakusanakanoshima-cho,**
**Fushimi-ku**
**Kyoto-shi,**
**Kyoto 612 (JP)**

(74) Representative: **Grünecker, Kinkeldey,
Stockmair & Schwanhäusser
Anwaltssozietät
Maximilianstrasse 58
D-80538 München (DE)**

(54) **Multilevel metallization forming method.**

(57) A first-level metallization (2) of aluminum or aluminum alloy is formed on a semiconductor substrate (1). A first $SiO_2$ layer (3)(i.e., a first interlevel insulator layer) and an SOG layer (4)(i.e., a second interlevel insulator layer) are sequentially formed on the semiconductor substrate (1) carrying thereon the first-level metallization (2) at temperatures below 500°C. This is followed by forming a hydrophobic molecular layer (10) on the SOG layer. Then, eventually a second $SiO_2$ layer (5)(i.e., a third interlevel insulator layer) is formed on the molecular layer (10). The first $SiO_2$ layer (3), the SOG layer (4), and the second $SiO_2$ (5) layer are etched into a desired pattern. Thereafter, a second-level metallization (9) is formed on the second $SiO_2$ layer (5).

FIG.6(a)

FIG.6(b)

FIG.6(c)

## BACKGROUND OF THE INVENTION

This is an invention in multilevel metallization. More particularly, it pertains to a high-yield, VLSI multilevel metallization.

In the VLSI multilevel metallization for forming a metal conductor film pattern (i.e., a metallization) to provide multilevel interconnection, dielectric layers are used as the interlevel insulator layers between various metallizations. As the VLSI density increases, the interlevel insulator layer plays a more important role and therefore its forming method is considered as an essential technique in the multilevel metallization. Such a formation method is required to form an interlevel insulator layer which has a planarized surface and attracts a minimum of water so as not to affect an overlying metallization.

Referring now to the accompanying drawing figures, a conventional multilevel metallization forming method will be discussed below.

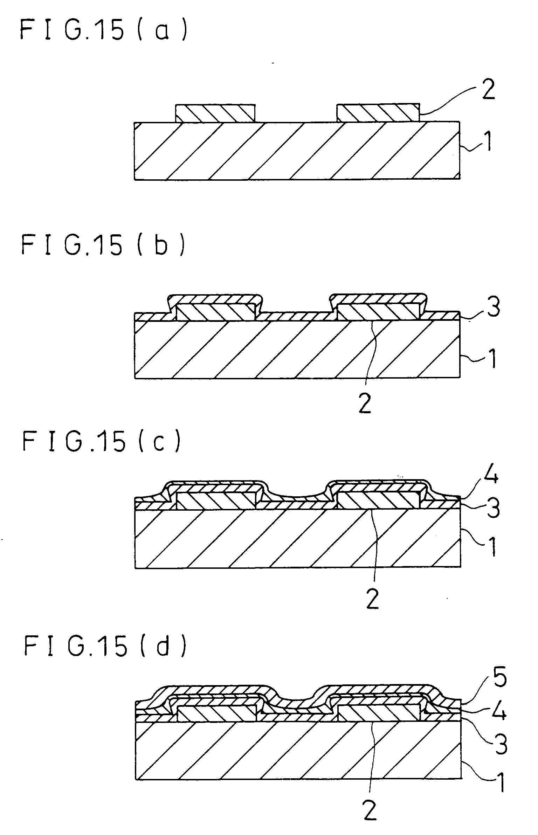

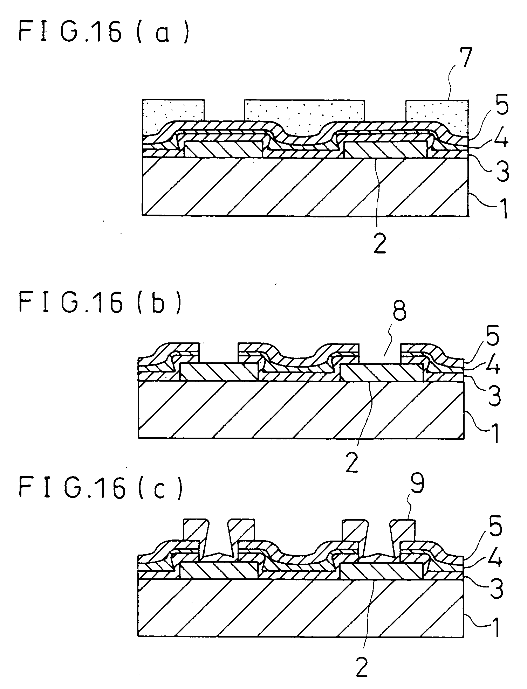

FIGURES **15** and **16**, comprised of **15a-d** and **16a-c** respectively, outline a conventional multilevel metallization forming technique.

As shown in FIG. **15a**, a first-level metallization **2** is formed on a semiconductor substrate **1**. More specifically, the first-level metallization **2** is formed as follows. A layer of Ti is deposited on the semiconductor substrate **1**, having a film thickness of 30 nm. Next, a layer of TiN is deposited having a film thickness of 70nm. Then, a layer of aluminum, which contains 1% of Si and 0.5 % of Cu and is hereinafter referred to as the aluminum alloy, is deposited having a film thickness of 700 nm. Next, a layer of TiN is deposited having a film thickness of 70 nm. A multiple layer of these deposited layers is patterned to form the first-level metallization **1** on the semiconductor substrate **1**.

Next, as shown in FIG. **15b**, a mixed gas of $SiH_4$ and $N_2O$ is introduced to the semiconductor substrate **1** including the first-level metallization **2**, and a plasma CVD process is performed to form a first $SiO_2$ layer **3** that acts as a first interlevel insulator layer.

Next, as shown in FIG. **15c**, a solution of silanol (e.g., SiOH) in alcohol is applied to the first $SiO_2$ layer **3**. Then, the silanol contained in the applied solution is solidified at a temperature of 380 °C, to form an SOG (spin-on glass) layer **4** that acts as a second interlevel insulator layer.

As shown in FIG. **15d**, a second $SiO_2$ layer **5** acting as a third interlevel insulator layer is formed on the SOG layer **4** the same way as the first $SiO_2$ layer **3** is formed.

Next, as shown in FIG. **16a**, a resist pattern **7** is formed on the second $SiO_2$ layer **5** to a desired pattern. Thereafter, the first $SiO_2$ layer **3**, the SOG layer **4**, and the second $SiO_2$ layer **5** are etched using the resist pattern **7** as a mask, to form a through-hole **8** (see FIG. **16b**).

Next, as shown in FIG. **16c**, a second-level metallization **9** is formed on the first-level metallization 2 and on the second $SiO_2$ layer 5. More specifically, the second-level metallization **9** is formed as follows. A layer of Ti is deposited having a film thickness of 30 nm. A layer of TiN is deposited having a film thickness of 70nm. Then, a layer of aluminum alloy containing 1% of Si and 0.5 % of Cu is deposited having a film thickness of 700 nm. Next, a layer of TiN is deposited having a film thickness of 70 nm. A multiple layer of these deposited layers is patterned to form the second-level metallization **9** on the first-level metallization **2** and on the second $SiO_2$ layer **5**.

A step portion is usually formed on the edge of the first-level metallization **2**. The first $SiO_2$ layer **3** not only mirrors such a step portion but also appears to enhance the defect. However, the SOG layer **4** of liquid glass as formed in the aforesaid way has the ability of smoothing the enhanced step portion. As described above, the SOG layer **4** is used as an interlevel insulator layer, thereby smoothing the step portion created by the first-level metallization **2**. Such arrangement inhibits not only the occurrence of disconnection in the second-level metallization **9** but also the short-circuiting of adjoining metallizations, thereby implementing a reliable multilevel metallization.

As the miniaturization of semiconductor device size progress, technologies capable of providing a good step coverage to a step portion with a high aspect ratio in the first-level metallization are demanded. Recently, as a solution to such a demand, an $SiO_2$ layer, formed by means of an atmospheric pressure CVD (APCVD) method employing TEOS (tetraethylorthosilicate) and ozone ($O_3$), has been proposed because it has a very superior step coverage. Such an $SiO_2$ layer is hereafter called a TEOS-$O_3$ layer. The TEOS-$O_3$ layer may be used as a substitute for the SOG layer **4**.

However, aluminum and aluminum alloy forming a first-level metallization have a low melting point. This produces the problem that the SOG layer and TEOS-$O_3$ layer must be formed at temperatures below 500 °C. It is well known in the art that interlevel insulator layers, formed at temperatures below 500 °C, provide a poor film quality (unrefined) and have the property of attracting water. Both the SOG layer and the TEOS-$O_3$ layer attract water from the air.

2

If water absorbed by SOG and TEOS-$O_3$ from the air and native water originally contained in these layers are expelled to outside the layers, then the expelled water corrodes the second-level metallization of aluminum alloy and disconnects same. This problem is most likely to occur to a through-hole for connecting the first- and second-level metallizations, particularly, to a through-hole with a diameter of 1 $\mu$m or less.

Conventionally, an interlevel insulator layer is subjected to a heat-treating process before a second-level metallization is formed, to get rid of water from the interlevel insulator layer. However, as the semiconductor device is miniaturized, the diameter of through-hole decreases, and because of the limitations of the heat-treating process temperature and the limitations of the heat-treating time due to the low melting point of aluminum or aluminum alloy forming the first-level metallization, such a heat-treating process has been proved incompetent to prevent the second-level metallization from suffering from defects such as corrosion and disconnection.

## SUMMARY OF THE INVENTION

Bearing in mind the above-noted problems with the prior art technique, the present invention was made. Accordingly, it is an object of the present invention to provide an improved multilevel metallization forming method capable of overcoming the prior art technique's problems. More specifically, the present invention is available even for an interlevel insulator layer formed at low temperatures below 500 degrees centigrade, since the present invention provides a means capable of preventing an unrefined interlevel insulator layer from attracting water. This prevents an overlying metallization from corroding and disconnecting.

In accordance with the present invention, an interlevel insulator layer, formed at temperatures below 500 °C, is coated with a hydrophobic molecular layer. This inhibits the interlevel insulator layer from being exposed to the air, thereby preventing the interlevel insulator layer from attracting water from the air.

The present invention provides a multilevel metallization forming method. This first method comprises:

a first step of forming a first-level metallization of aluminum or aluminum alloy on a semiconductor substrate;

a second step of forming an interlevel insulator layer on the semiconductor substrate including the first-level metallization, at a low temperature;

a third step of forming a hydrophobic molecular layer on the interlevel insulator layer;

a fourth step of etching the interlevel insulator layer including the molecular layer into a desired pattern; and

a fifth step of forming a second-level metallization on the etched interlevel insulator layer.

In accordance with the first multilevel metallization forming method, the hydrophobic molecular layer is formed on the interlevel insulator layer formed at temperatures below 500 °C and thereafter the interlevel insulator layer is etched into a desired pattern. As a result of such arrangement, the interlevel insulator layer is not exposed to the air during the etching step. Although the interlevel insulator layer has the property of attracting much water because of its low deposit temperature, it actually attracts little or no water from the air because of the above-noted arrangement. The occurrence of corrosion and disconnection in the multilevel metallization is prevented.

The present invention provides another multilevel metallization forming method. This second method comprises:

a first step of forming a first-level metallization of aluminum or aluminum alloy on a semiconductor substrate;

a second step of forming an interlevel insulator layer on the semiconductor substrate including the first-level metallization, at temperatures below 500 °C;

a third step of etching the interlevel insulator layer into a desired pattern;

a fourth step of forming a hydrophobic molecular layer on the etched interlevel insulator layer; and

a fifth step of forming a second-level metallization on the molecular layer.

In accordance with the second multilevel metallization forming method, the hydrophobic molecular layer is formed on the etched interlevel insulator layer and thereafter the second-level interlevel insulator layer is formed on the molecular layer. As a result of such arrangement, the interlevel insulator layer is not exposed to the air during the second-level interlevel insulator layer forming step. Although the interlevel insulator layer has the property of attracting much water because of its low deposit temperature, it actually attracts little or no water from the air because of the above-noted arrangement. The occurrence of corrosion and disconnection in the multilevel metallization is prevented.

In each of the first and second multilevel metallization forming methods, it is preferable that the molecular layer is formed by means of a silylation. This arrangement provides the following advantages.

EP 0 678 913 A1

1. Since silylation takes places easily at temperatures ranging from room temperature to 120-130 °C, this provides a greater control on the formation of the molecular layer.

2. Silylation provides high adhesion stability between the substrate and the molecular layer that physical adsorption cannot provide.

3. Reaction gas, used for silylation, is a gas that is employed in the LSI processing as a pre-treatment agent for allowing a surface to be resist-wetted. It has been proved that the use of such a gas produces no problems (e.g., LSI contamination by impurities contained).

4. The molecular layer consists of chemically bonded molecules. In other words, the molecules are not formed in a layer form, so that the molecular layer can easily be washed off by water or removed by a plasma treatment. Accordingly, the molecular layer is easy to deal with in the fabrication process.

5. Once the molecular layer is formed on a part of the semiconductor substrate, this part stops reacting with the reaction gas. This allows the molecular layer to be formed on the entire semiconductor substrate surface having a uniform film thickness.

6. Reaction gas, used for silylation, has large-size molecules, and little or no $H_2O$ enters even an unrefined interlevel insulator layer. This provides a good hydrophobic nature.

7. Even if there are surface irregularities such as voids in the interlevel insulator layer and there are differences in the reaction gas arrival time between the project portions and the recess portions, the molecular layer can be formed having a uniform film thicknesses along all the surfaces of the interlevel insulator layer including the bottom of the void.

In each of the first and second multilevel metallization forming methods, it is preferable that the molecular layer is formed by a surface-active agent. This ensures the formation of the hydrophobic molecular layer on the interlevel insulator layer.

It is preferable that each of the first and second multilevel metallization forming methods further comprises a step which is performed between the second and third steps, to remove water contained in the interlevel insulator layer by heating the semiconductor substrate including the interlevel insulator layer at temperatures below 500 °C.

As a result of such arrangement, the water contained in the interlevel insulator layer is expelled before the hydrophobic molecular layer is formed on the interlevel insulator layer. Accordingly, even if there is a long interval of time between the formation of the interlevel insulator layer and that of the molecular layer, the occurrence of corrosion and disconnection in the multilevel metallization is prevented because the amount of water contained in the interlevel insulator layer has already been kept lower by the pre-heating treatment.

It is preferable that the second multilevel metallization forming method further comprises a step which is performed between the third and fourth steps, to remove water contained in the interlevel insulator layer by heating the semiconductor substrate including the interlevel insulator layer at temperatures below 500 °C.

As a result of such arrangement, the water contained in the interlevel insulator layer is expelled before the hydrophobic molecular layer is formed on the interlevel insulator layer. Accordingly, even if there is a long interval of time between the formation of the interlevel insulator layer and that of the molecular layer, the occurrence of corrosion and disconnection in the multilevel metallization is prevented because the amount of water contained in the interlevel insulator layer has already been kept lower by the pre-heating treatment.

The present invention provides still another multilevel metallization forming method. This third method comprises:

a first step of forming a first-level metallization of aluminum or aluminum alloy on a semiconductor substrate;

a second step of forming an interlevel insulator layer on the semiconductor substrate including the first-level metallization at temperatures below 500 °C;

a third step of forming a first hydrophobic molecular layer on the interlevel insulator layer;

a fourth step of etching the interlevel insulator layer including the first molecular layer into a desired pattern;

a fifth step of forming a second hydrophobic molecular layer on the etched interlevel insulator layer; and

a sixth step of forming a second-level metallization on the second molecular layer.

In accordance with the third multilevel metallization forming method, the first hydrophobic molecular layer is formed on the interlevel insulator layer formed at temperatures below 500 °C. Thereafter, the interlevel insulator layer is etched into a desired pattern and the second hydrophobic molecular layer is formed on the etched interlevel insulator layer. Then, the second-level metallization is formed on the second

4

EP 0 678 913 A1

molecular layer. As a result of such arrangement, the interlevel insulator layer is not exposed to the air during the etching step and the second-level metallization forming step. Although the interlevel insulator layer has the property of attracting much water because of its low deposit temperature, it actually attracts little or no water from the air because of the above-noted arrangement. The occurrence of corrosion and disconnection in the multilevel metallization is prevented.

In the third multilevel metallization forming method, it is preferable that each molecular layer is formed by a surface-active agent. This ensures the formation of each of the first and second hydrophobic molecular layers over the interlevel insulator layer.

In the third multilevel metallization forming method, it is preferable that the surface-active agent contains silicon or germanium. This ensures the formation of the hydrophobic molecular layer on the interlevel insulator layer.

In each of the first, second, and third multilevel metallization forming methods, it is preferable that the surface-active agent is a silane compound, siloxane compound, disilazane compound, trisilazane compound, piperazine compound, amino germanium compound, or germanium halide compound.

In each of the first, second, and third multilevel metallization forming methods, it is preferable that the second step utilizes a CVD (chemical vapor deposition) process to deposit an organosilane-family material to form an interlevel insulator layer on the semiconductor substrate including the first-level metallization. This ensures the formation of the interlevel insulator layer at temperatures below 500 °C.

In each of the first, second, and third multilevel metallization forming methods, it is preferable that the second step utilizes a liquid application process to deposit a silanol-family material to form an interlevel insulator layer on the semiconductor substrate including the first-level metallization. This ensures the formation of the interlevel insulator layer at below 500 °C.

**BRIEF DESCRIPTION OF THE DRAWINGS**

FIGURE **1** is a chart showing results of FTIR (Fourier Transform infrared) measurements on different insulator layers formed by means of LPCVD and APCVD.

FIGURE **2a** is a schematic illustrating an interlevel insulator layer surface that has fine voids and attracts water, and FIG. **2b** is a schematic illustrating another interlevel insulator layer surface that has no fine voids and attracts little or no water.

FIGURE **3** is a chart showing the relationship of the amount of attracted water versus the keeping time in the air.

FIGURE **4**, comprised of **4a-4c**, shows steps of the formation of a molecular layer in each preferred embodiment of the present invention.

FIGURE **5**, comprised of **5a-5d**, shows steps of the formation of a multilevel metallization according to the first embodiment of the present invention.

FIGURE **6**, comprised of **6a-6c**, shows subsequent steps of the aforesaid multilevel metallization formation according to the first embodiment of the present invention.

FIGURE **7** depicts in cross section a multilevel metallization according to the first embodiment of the present invention for the purpose of measuring its electrical characteristics.

FIGURE **8**, comprised of **8a-8d**, shows steps of the formation of a multilevel metallization according to the second embodiment of the present invention.

FIGURE **9**, comprised of **9a-9c**, shows subsequent steps of the aforesaid multilevel metallization formation according to the second embodiment of the present invention.

FIGURE **10**, comprised of **10a-10d**, shows steps of the formation of a multilevel metallization according to the third embodiment of the present invention.

FIGURE **11**, comprised of **11a-11c**, shows subsequent steps of the aforesaid multilevel metallization formation according to the third embodiment of the present invention.

FIGURE **12** is a chart illustrating the relationship of the amount of attracted water versus the heating temperature.

FIGURE **13** is a diagram outlining a first molecular layer forming device used in each of the embodiments of the present invention.

FIGURE **14** is a diagram outlining a second molecular layer forming device used in each of the embodiments of the present invention.

FIGURE **15**, comprised of **15a-15d**, shows steps of the formation of a multilevel metallization according to a conventional technique.

FIGURE **16**, comprised of **16a-16c**, shows subsequent steps of the aforesaid conventional multilevel metallization formation.

5

## DETAILED DESCRIPTION OF THE INVENTION

Before describing a multilevel metallization forming method according to preferred embodiments of the present invention, a system for forming a molecular layer is first discussed.

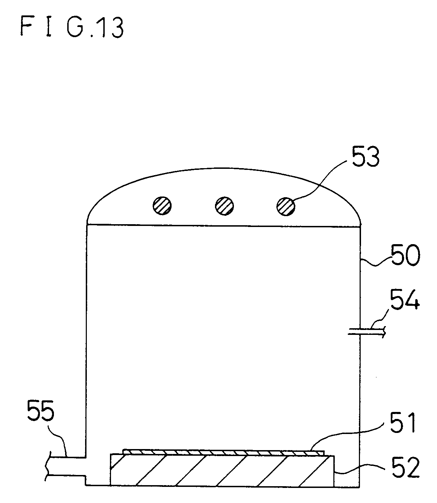

FIGURE 13 illustrates in cross section a first molecular layer forming device. As shown in FIG. 13, a reaction chamber 50 includes the following: a substrate support platform 52 onto which a semiconductor substrate 51 is placed; a heater 53 of an infrared lamp for heating the semiconductor substrate 51; an inlet 54 through which air, water vapor, and silylation agent's vapor are introduced into the reaction chamber 50; and an outlet 55 through which gas within the reaction chamber 50 is vented. Additionally, the reaction chamber 50 has a ceiling of a heat reflector with a curved surface for uniform application of heat from the heater 53 to the semiconductor substrate 51.

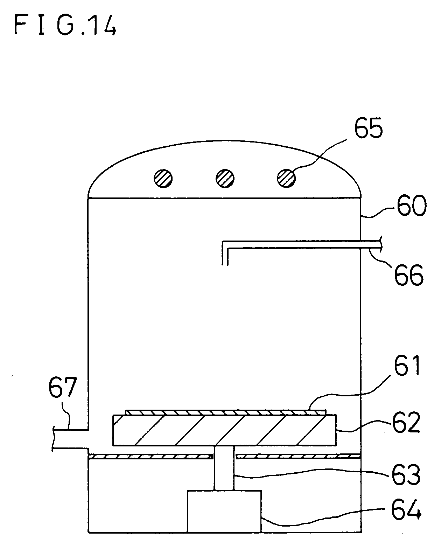

FIGURE 14 illustrates in cross section a second molecular layer forming device. As shown in FIG. 14, a reaction chamber 60 includes the following: a substrate support platform 62 onto which a semiconductor substrate 61 is placed; a substrate rotating means 64 which holds a rotation axis 63 of the substrate support platform 62 in such a way that the rotation axis 63 can rotate freely; a heater 65 of an infrared lamp for heating the semiconductor substrate 61; an inlet 66 through which air, water vapor, or a silylation agent solution is introduced into the reaction chamber 60; and an outlet 67 through which gas within the reaction chamber 60 is vented.

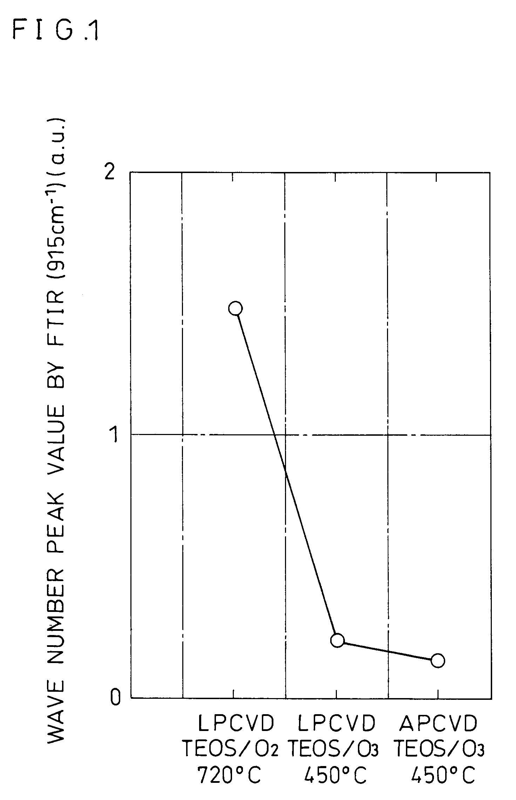

The molecular layer formation is described below. Interlevel insulator layers for use in the multilevel metallization are formed at low temperatures and they have a poor film quality accordingly (in other words, their surfaces are unrefined). The reason for this is explained by making reference to FIG. 1. FIG. 1 compares three different insulator layers. The first insulator layer was deposited by means of an LPCVD process (source gas used: TEOS and $O_2$; deposit temperature: 720 °C). The second insulator layer was deposited by means of an LPCVD process (source gas used: TEOS and $O_3$; deposit temperature: 450 °C). The third insulator layer was deposited by means of an APCVD process (source gas used: TEOS and $O_3$: deposit temperature: 450 °C). These three insulator layers were analyzed using an FTIR method, and FIG. 1 shows the results. The numbers on the ordinate indicate the wave number peak value (in arbitrary unit). The peak value indicates the Si-O bond strength, and greater peak value indicates stronger Si-O bond. As can be seen from FIG. 1, the first insulator layer has a great peak value. On the other hand, each of the second and third insulator layers was found to be a poor $SiO_2$ layer whose Si-O bond is weak. Both the second and third insulator layers had an unrefined layer surface.

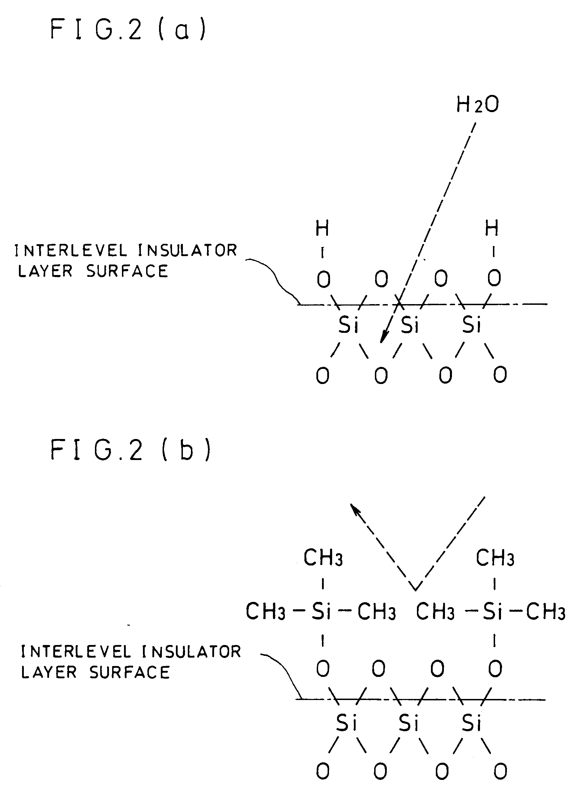

An insulator layer, formed at a low temperature, has a weak Si-O bond structure and is poor in the film quality. In other words, such an insulator layer is a layer out of stoichiometric proportion, so that it contains many dangling bonds, Si-OH bonds, and fine voids. Accordingly, insulator layers formed at low temperatures are most likely to take water from the air. FIGURE 2a, on the one hand, shows an interlevel insulator layer surface with fine voids therein. The FIG. 2a surface is likely to take water from the air. FIGURE 2b, on the other hand, shows another interlevel insulator layer surface without fine voids. The FIG. 2b surface is thus unlikely to take water from the air. In accordance with the present invention, a molecular layer is formed on a surface like the FIG. 2b interlevel insulator layer surface. This arrangement makes the interlevel insulator layer hydrophobic to prevent water attraction.

A chemical reaction taking place when forming a molecular layer is as follows:

$$2Si\text{-}OH + (CH_3)_3SiNHSi(CH_3)_3 \rightarrow 2Si\text{-}O\text{-}Si(CH_3)_3 + NH_3\uparrow$$

Si-OH of this formula indicates a substrate surface state. An unrefined insulator layer will undergo such an Si-OH surface state when brought into contact with the air. Surface coating with -OH occurs even to an aluminum alloy layer and a thin oxide layer is formed thereon. This formed oxide layer is an -OH state.

If the Si-OH substrate surface comes in contact with trimethyldisilazane, this causes a chemical reaction so that H of Si-OH is replaced with $Si(CH_3)_3$. This replacement produces $NH_3$. This produced $NH_3$ is discharged in the form of gas (indicated by ↑ arrow in the aforesaid formula). When covered with hydrocarbon, the substrate surface becomes hydrophobic (water repellent) so that it attracts no water from the air (see FIG. 2b). The hydrophobic nature of hydrocarbon is discussed by J. L. Moilliet in his work entitled "Waterproofing and Waterrepellency," ELSEVIER PUBLISHING COMPANY (1963).

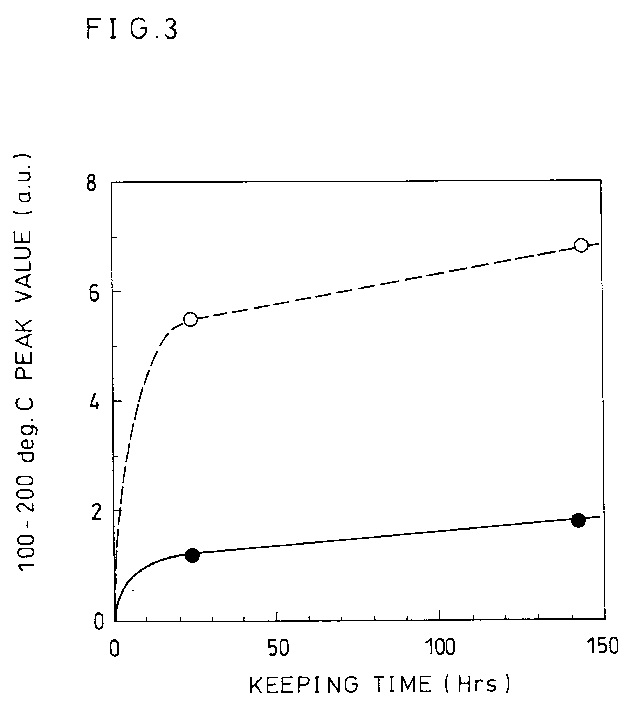

FIGURE 3 shows the effect of a hydrophobic substrate surface. Insulator layers of $SiO_2$ were used as samples which were formed by means of APCVD (source gas used: TEOS and $O_3$; deposit temperature: 450 °C) and were kept in air. Thereafter, these with- or without-molecular layer samples were heated from 100 °C up to 200 °C, and at the same time the mass analysis of water was carried out to each sample using a thermal desorption spectroscopy. The amount of attracted water was identified from the amount of discharged water. In FIG. **3**, broken line indicates the amount of attracted water in the case of the without-molecular layer sample, whereas solid line indicates the amount of attracted water in the case of the with-molecular layer sample. In the former sample, the amount of attracted water rapidly increased 24 hours after the deposit. Conversely, in the latter sample, it was proved that the amount of attracted water was well controlled so that it increased gradually at a low rate. The latter sample was formed as follows. First, an $SiO_2$ insulator layer was formed, and within a few hours therefrom a molecular layer was formed on the $SiO_2$ insulator layer. It seems from FIG. **1** that the amount of attracted water increased for a period of 24 hours from the deposit. However, it is conceivable that such an increase results from the water taken in prior to the formation of the molecular layer.

The molecular layer is formed by means of silylation. The reasons are as follows. $H_2O$ or -OH easily reacts with, for example, HMDS (hexamethyldisilazane), at temperatures ranging from room temperature up to 120-130 °C, thereby providing a greater control on the molecular layer formation. HMDS reacts with the substrate and they bond together by means of chemical adsorption, not by physical adsorption. Therefore, silylation can provide higher adhesion stability between the substrate and the molecular layer. In the LSI processing, HMDS has been used as a pretreatment agent for allowing a surface to be resist-wetted before the application of resist. It has been proved that the use of HMDS in the LSI processing produces no problems (e.g., LSI contamination by contained impurities). Additionally, the molecular layer consists of chemically bonded molecules. In other words, the molecular layer does not exist in the form of a layer, so that it can be washed off by water or removed by a plasma treatment. Accordingly, the molecular layer is easy to deal with in the fabrication processing.

Further, once the substrate surface is covered with a molecular layer of $CH_3$ groups, the substrate surface no longer reacts with $CH_3$ contained in a reaction gas and there is no further chemical reaction.

A reaction gas containing HMDS has large-size molecules and little or no $H_2O$ enters even an unrefined interlevel insulator layer.

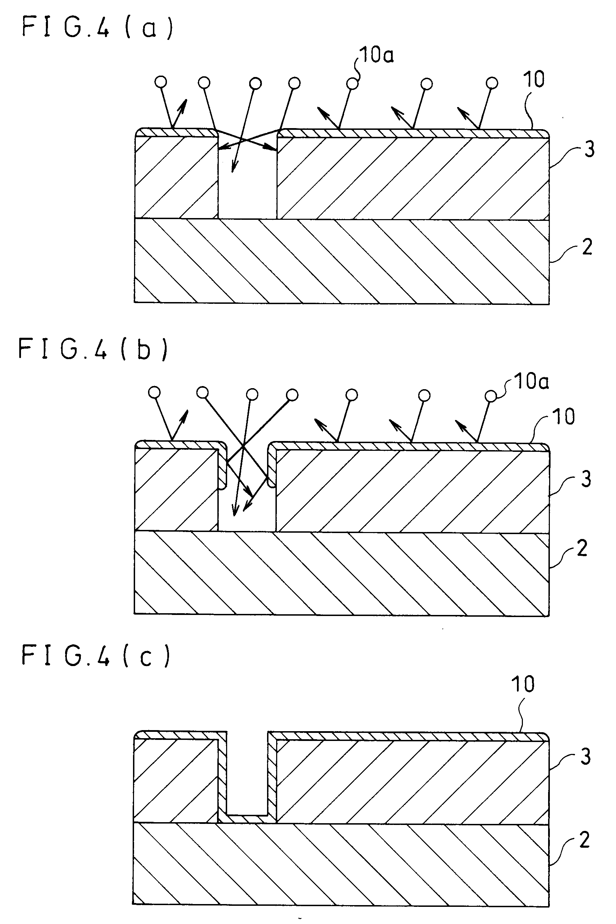

FIGURES **4a-4c** show subsequent steps of the formation of a molecular layer. **2** is a first-level metallization of, for example, aluminum alloy. **3** is an interlevel insulator layer. **10** is a molecular layer. **10a** is a molecule of a reaction gas. As shown in the figure, there are surface irregularities such as holes in the surface of the interlevel insulator layer **3**. Although there are differences in the reaction gas arrival time between the project portions and the recess portions in the surface of the interlevel insulator layer **3**, the molecular layer **10** is formed having a uniform film thickness along all the surfaces of the interlevel insulator layer **3**. More specifically, as shown in FIG. **4a**, the project portion is first covered with $CH_3$. With regard to such a location covered with $CH_3$, the chemical reaction comes to a halt. As a result, the project portion, covered with $CH_3$, repels an arriving reaction gas (see FIG. **4b**), and the repelled reaction gas moves into a reaction cite to react therewith. This phenomenon repeatedly occurs within a short time. Then, as shown in FIG. **4c**, even the bottom of the hole is covered with the molecular layer **3**.

**EMBODIMENT 1**

A first embodiment of the present invention is described by making reference to the accompanying drawing figures.

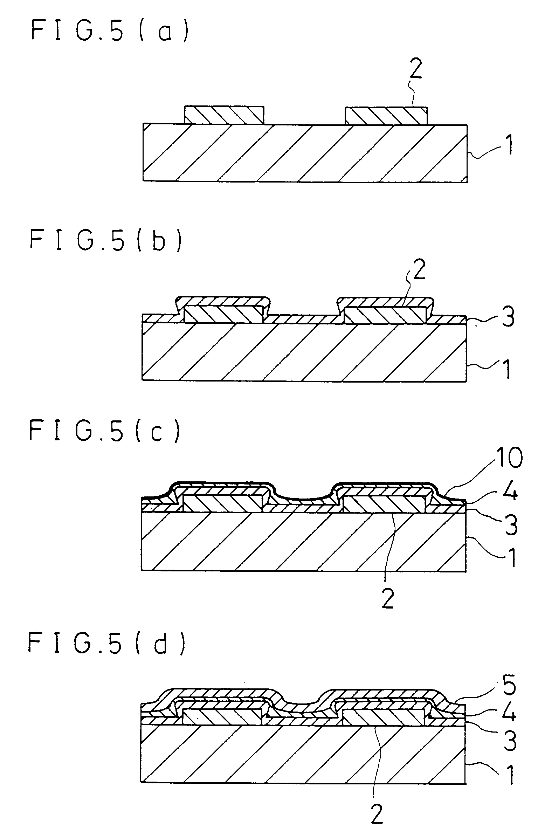

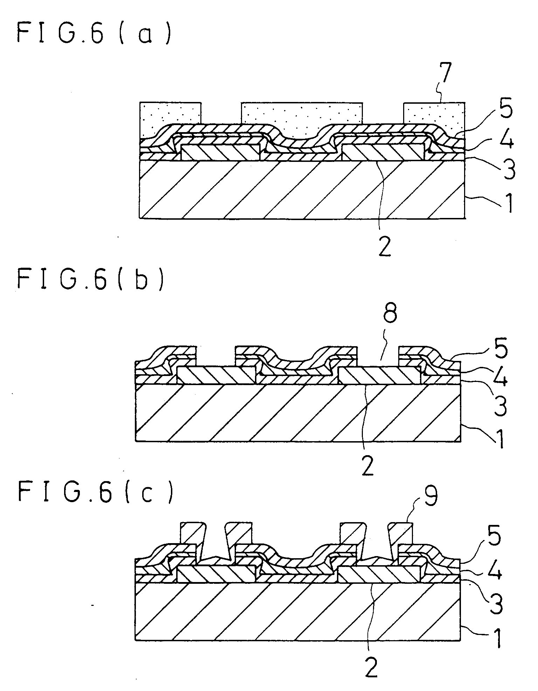

FIGURES **5** and **6** illustrate in cross section subsequent steps of the formation of a multilevel metallization according to the first embodiment of the invention.

As shown in FIG. **5a**, a 30-nm thick Ti layer, a 70-nm thick TiN layer, a 700-nm thick aluminum alloy layer, and a 70-nm TiN layer are formed, in that order, on the surface of a semiconductor substrate **1**. A multiple layer, comprised of those metal layers, is patterned to form a first-level metallization **2**.

Next, a mixed gas of $SiH_4$ and $N_2O$ is supplied to the semiconductor substrate **1** carrying thereon the first-level metallization **2**, and a plasma CVD process is performed to form a first $SiO_2$ layer **3** acting as a first interlevel insulator layer on the semiconductor substrate **1** (see FIG. **5b**).

Next, a solution of silanol in alcohol is applied to the surface of the first $SiO_2$ layer **3**. Then, the silanol contained in the applied solution is solidified at a temperature of 380 °C to form an SOG (spin-on glass) layer **4** acting as a second interlevel insulator layer on the first $SiO_2$ layer **3** (see FIG. **5c**).

Thereafter, a hydrophobic molecular layer **10** is formed on the SOG layer **4** using the first molecular layer forming device shown in FIG. **13**. However, where there is a long interval of time (for more than several hours) between the formation of the SOG layer **4** and the formation of the molecular layer **10**, the semiconductor substrate **1** carrying thereon the SOG layer **4** should be heated at temperatures below 500 °C (e.g., a few hundred degrees centigrade), to get rid of water contained in the SOG layer **4**. Such a heat-treating process is performed by the heater **53** mounted in the reaction chamber **50**.

7

Next, in order to form hydroxyl groups (i.e., -OH) on the surface of the SOG layer **4**, air or water vapor is supplied in the reaction chamber **50** for only a few seconds via the inlet **54**. As a result, the SOG layer **4** is exposed to the introduced air or water vapor for a very short time. Thereafter, HMDS is heated at a temperature of 130 °C, and HMDS vapors are supplied to the reaction chamber **50** for a few minutes via inlet **54** to form the hydrophobic molecular layer **10** on the SOG layer **4**.

Next, as shown in FIG. **5d**, a second $SiO_2$ layer **5** is formed on the SOG layer **4** carrying thereon the molecular layer **10** (not shown in the figure) in the same way as the aforesaid first $SiO_2$ layer **5** is formed. This second $SiO_2$ layer **5** acts as a third interlevel insulator layer.

Next, as shown in FIG. **6a**, a resist pattern **7** is formed on the second $SiO_2$ layer **5** in such a way so as to form a desired pattern. Thereafter, using the resist pattern **7** as a mask, the first $SiO_2$ layer **3**, the SOG layer **4**, and the second $SiO_2$ layer **5** are etched to form a through-hole **8** as shown in FIG. **6b**.

Next, as shown in FIG. **6c**, a 30-nm thick Ti layer, a 70-nm thick TIN layer, a 700-nm thick aluminum alloy layer, and a 70-nm TiN layer are formed, in that order, on the first-level metallization **2** and on the second $SiO_2$ layer **5**. A multiple layer, comprised of those deposited metal layers, is patterned to form a second-level metallization **9**.

An evaluation test, which was employed to evaluate the first embodiment of the present invention, is described below.

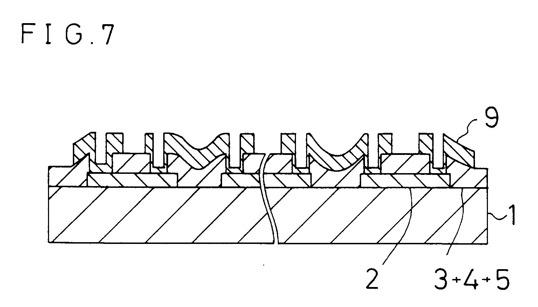

FIGURE **7** illustrates in cross section the structure of a multilevel metallization. This multilevel metallization structure was used to measure the yield of multilevel metallization. The first-level metallization **2** was connected in series with the second-level metallization **9** via a hundred thousand through-holes. Therefore, electrical characteristics of interconnections disconnected by the attracted water were easily evaluated.

The FIG. **7** multilevel metallization was prepared according to the aforesaid steps (2500 samples). These samples were measured in the electrical characteristic to find the yield of the multilevel metallization, the result of which is shown in TABLE **1**. As shown in TABLE **1**, the present invention's yield was above 99%, and the through-hole diameter was 1.2 $\mu$m. On the other hand, a conventional multilevel metallization, prepared by the same steps as the first embodiment except for the step of forming the molecular layer **10**, produced a yield of about 74% (the through-hole diameter: 1.0 $\mu$m).

TABLE 1

|  | YIELD (%) |
|---|---|
| FIRST EMBODIMENT | 99.2 |
| PRIOR ART | 74.4 |

In accordance with the first embodiment, the SOG layer **4** is formed and thereafter the molecular layer **10** of HMDS that is hydrophobic is formed on the SOG layer **4**. This arrangement prevents the hygroscopic SOG layer **4** with a high hygroscopic property from attracting water. This prevents the occurrence of electrical disconnections in the second-level metallization **9**.

**EMBODIMENT 2**

A second preferred embodiment of the present invention is described by reference to the accompanying drawing figures.

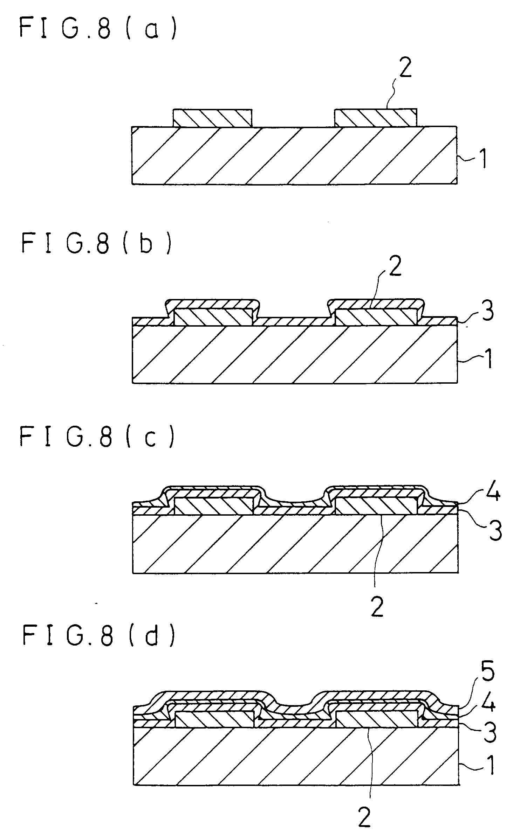

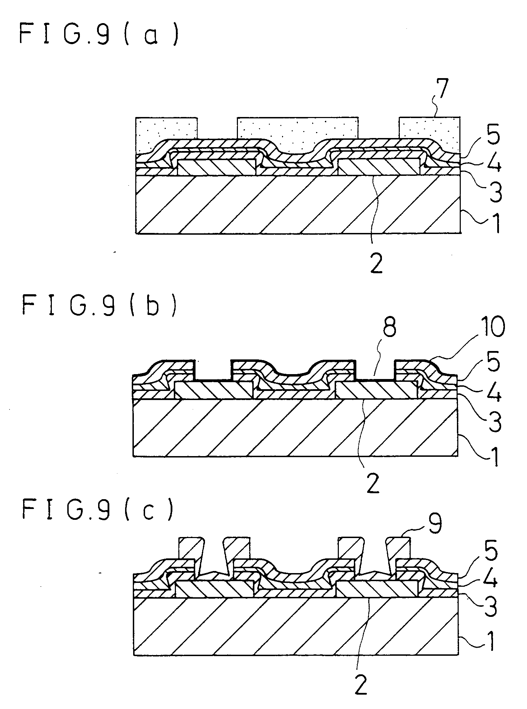

FIGURES **8** and **9** illustrate in cross section subsequent steps of the formation of a multilevel metallization according to the second embodiment of the invention.

As in the first embodiment, the first-level metallization **2** is formed on the semiconductor substrate **1** - (see FIG. **8a**). Next, formed on the semiconductor substrate **1** including the first-level metallization **2** is the first $SiO_2$ layer **3** acting as a first interlevel insulator layer (FIG. **8b**). This is followed by the formation of the SOG layer **4** acting as a second interlevel insulator layer on the first $SiO_2$ layer **3** (see FIG. **8c**).

Next, unlike the first embodiment, the second $SiO_2$ layer **5** acting as a third interlevel insulator layer is formed on the SOG layer **4**, skipping the step of forming the molecular layer **10** (see FIG. **8d**).

Next, as shown in FIG. **9a**, the resist pattern **7** is formed on the second $SiO_2$ layer **5** in such a way so as to form a desired pattern. Thereafter, using the resist pattern **7** as a mask, the first $SiO_2$ layer **3**, the SOG layer **4**, and the second $SiO_2$ layer **5** are etched to form the through-hole **8** as shown in FIG. **9b**. Then, like the first embodiment, the hydrophobic molecular layer **10** is formed on the second $SiO_2$ layer **5**.

Next, as shown in FIG. **9c**, a 30-nm thick Ti layer, a 70-nm thick TiN layer, a 700-nm thick aluminum alloy layer, and a 70-nm TiN layer are formed, in that order, on the first-level metallization **2** and on the second $SiO_2$ layer **5**. A multiple layer, comprised of those metal layers, is patterned to form the second-level metallization **9**.

An evaluation test, which was employed to evaluate the second embodiment of the present invention, is described below.

The FIG. **7** multilevel metallization was prepared according to the aforesaid steps (2500 samples). These samples were measured in the electrical characteristic to find the yield of multilevel metallization, the result of which is shown in TABLE **2**. As shown in TABLE **2**, the present invention's yield was above 97%, and the through-hole diameter was 1.0 $\mu$m. On the other hand, a conventional multilevel metallization, prepared by the same steps as the first embodiment except for the step of forming the molecular layer **10**, produced a yield of 57% (the through-hole diameter: 1.0 $\mu$m).

TABLE 2

|  | YIELD (%) |
| --- | --- |
| SECOND EMBODIMENT | 97.4 |
| PRIOR ART | 57.0 |

In a multilevel metallization with through-holes having a diameter of 1 $\mu$m, the SOG layer **4** has a very thin film thickness in a through-hole and disconnection is likely to occur to the second-level metallization **9**. However, in accordance with the second embodiment, etching is performed to the SOG layer **4** that is very hygroscopic and thereafter the molecular layer **10** made of HMDS that is hydrophobic is formed. This arrangement prevents the SOG layer **4** from attracting water. This prevents the occurrence of electrical disconnection in the second-level metallization **9**.

**EMBODIMENT 3**

A third preferred embodiment of the present invention is described by reference to the accompanying drawing figures.

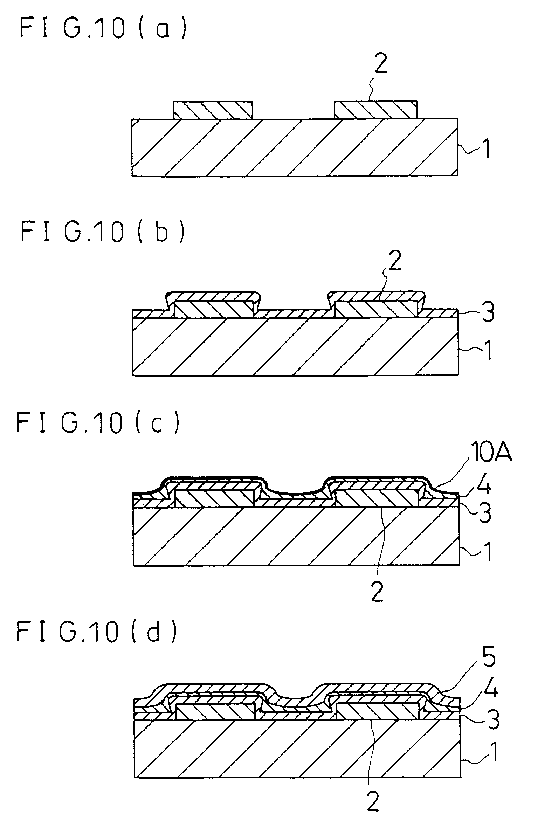

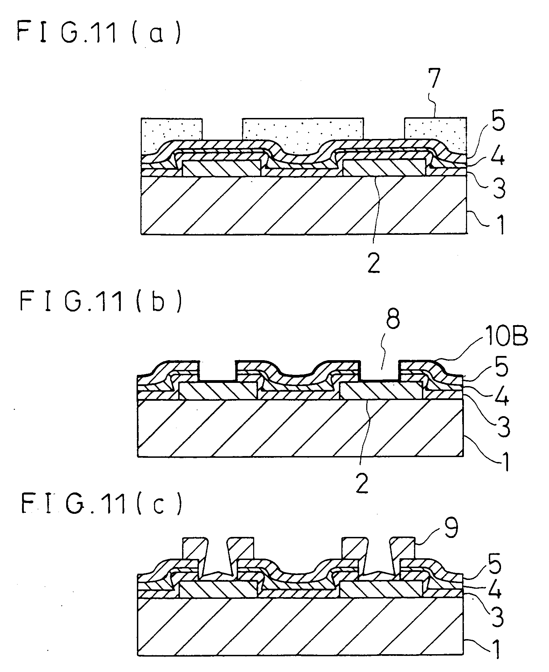

FIGURES **10** and **11** illustrate in cross section subsequent steps of the formation of a multilevel metallization according to the second embodiment of the invention.

As in the first embodiment, the first-level metallization **2** is formed on the semiconductor substrate **1** (see FIG. **10a**). Next, formed on the semiconductor substrate **1** carrying thereon the first-level metallization **2** is the first $SiO_2$ layer **3** acting as a first interlevel insulator layer (FIG. **10b**). This is followed by the formation of the SOG layer **4** acting as a second interlevel insulator layer on the first $SiO_2$ layer **3** (see FIG. **10c**).

Next, a first hydrophobic molecular layer **10A** is formed on the SOG layer **4**. Then, as shown in FIG. **10d**, the second $SiO_2$ layer **5** acting as a third interlevel insulator layer is formed on the SOG layer **4** carrying thereon the first molecular layer **10A** (not shown in FIG. **10d**).

Next, as shown in FIG. **11a**, the resist pattern **7** is formed on the second $SiO_2$ layer **5** in such a way so as to form a desired pattern. Thereafter, using the resist pattern **7** as a mask, the first $SiO_2$ layer **3**, the SOG layer **4**, and the second $SiO_2$ layer **5** are etched to form the through-hole **8** as shown in FIG. **11b**.

Next, a second hydrophobic molecular layer **10B** is formed on the first-level metallization **2** as well as on the second $SiO_2$ layer **5**. Then, as shown in FIG. **11a**, a 30-nm thick Ti layer, a 70-nm thick TiN layer, a 700-nm thick aluminum alloy layer, and a 70-nm TiN layer are formed, in that order, on the first-level metallization **2** and on the second $SiO_2$ layer **5**. A multiple layer, comprised of these deposited metal layers, is patterned to form the second-level metallization **9**.

An evaluation test, which was employed to evaluate the second embodiment of the present invention, is described below.

The multilevel metallization was prepared according to the aforesaid steps (2500 samples) . These samples were measured in the electrical characteristic to find the yield of multilevel metallization, the result of which is shown in TABLE **3**. As shown in TABLE **3**, the present invention's yield was above 99% and the through-hole diameter was 1.0 $\mu$m. On the other hand, a conventional multilevel metallization, prepared by the same steps as the first embodiment except for the step of forming the molecular layer **10**, produced a yield of 57% (the through-hole diameter: 1.0 $\mu$m).

TABLE 3

| | YIELD (%) |
|---|---|
| THIRD EMBODIMENT | 99.4 |
| PRIOR ART | 57.0 |

In accordance with the third embodiment, the first molecular layer **10A** is formed on the SOG layer **4**, and the second molecular layer 10B is formed after the SOG layer **4** is etched. Such arrangement almost perfectly prevents the SOG layer **4** that is very hygroscopic from attracting water, thereby almost perfectly preventing the occurrence of electrical disconnection in the second-level metallization **9**.

In each of the aforesaid embodiments of the present invention, a three-layered structure, comprised of the first $SiO_2$ layer **3**, the SOG layer **4**, and the second $SiO_2$ layer **5**, is employed (i.e., a layered structure of three interlevel insulator layers). Other layered structures, comprised of any number of interlevel insulator layers, may be used with the same effects.

In each of the aforesaid embodiments, a mixed gas of $SiH_4$ and $N_2O$ is supplied to form the first and second $SiO_2$ layers **3**, **5** by means of a plasma CVD method. A mixed gas of TEOS and $O_2$ or a mixed gas of TEOS and $O_3$ may be used to form the first and second interlevel insulator layers by means of a plasma CVD or APCVD method.

In each of the aforesaid embodiments, the SOG layer **4** acts as a second interlevel insulator layer. However, instead of using the SOG layer **4**, a TEOS-$O_3$ layer (see the prior art description previously made) may be used with the same effect.

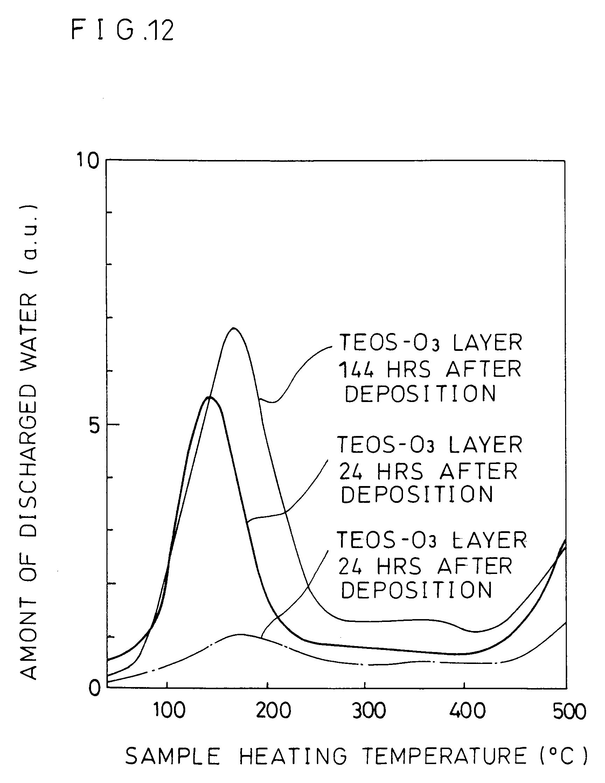

FIGURE **12** is a characteristic diagram showing the fact that TEOS-$O_3$ has the property of attracting water. A TEOS-$O_3$ layer was heated, and water, discharged from the TEOS-$O_3$, was mass-analyzed. The results of the mass analysis are shown in FIG. **12**. Three different samples were used, (1) a TEOS-$O_3$ layer which had been left in the air for 24 hours after the deposition thereof; (2) a TEOS-$O_3$ layer which had been left in the air for 144 hours after the deposition thereof; and (3) a P-TEOS layer which was formed from a mixed gas of TEOS and $O_2$ by means of a plasma CVD method and which had been left in the air for 24 hours after the deposition thereof. As seen from FIG. **12**, these three samples each discharged a maximum of water at temperatures between 100-200 °C and it was proved that the TEOS-$O_3$ attracted water about six times the P-TEOS layer. This shows that the TEOS-$O_3$ layer has the property of attracting water as much as the SOG layer. In other words, the TEOS-$O_3$ suffers from the same problem as previously described.

TABLE **4** shows the relationship of the formation method/material versus the fineness/hygroscopic property of the interlevel insulator layer.

**TABLE 4**

| METHOD | SOURCE GAS | FINENESS | HYGROSCOPICITY |
|---|---|---|---|
| PCVD | $SiH_4$ group<br>Organosilane family | Fine | Low |
| LPCVD<br>(APCVD) | $SiH_4$ family<br>(P may be contained)<br>Organosilane family | ↕ | ↕ |
| Liquid<br>Appln. | Silanol family | Unrefined | High |

As seen from TABLE **4**, only the interlevel insulator layer formed by a plasma CVD method using a $SiH_4$-family material is low in hygroscopicity. Accordingly, the present invention finds applications in forming an interlevel insulator layer from $SiH_4$-family material by means of a plasma CVD method.

In each of the aforesaid embodiments of the present invention, HMDS, which is a disilazane compound, is used to form a molecular layer. However, other disilazane compounds, silane compounds, siloxane compounds, trisilazane compounds, piperazine compounds, amino germanium compounds, or germanium halide compounds may be used.

In each of the aforesaid embodiments of the present invention, with the first molecular layer forming device, the hydrophobic molecular layer is formed by supplying HMDS vapors for a few minutes. However, the second molecular layer forming device may be used to form a molecular layer by dropping a solution of HMDS onto the surface of the semiconductor substrate 1 while rotating the substrate support platform **62**.

## Claims

1. A multilevel metallization forming method comprising:

   a first step of forming a first-level metallization of aluminum or aluminum alloy on a semiconductor substrate;

   a second step of forming an interlevel insulator layer on said semiconductor substrate including said first-level metallization, at temperatures below 500 °C;

   a third step of forming a hydrophobic molecular layer on said interlevel insulator layer;

   a fourth step of etching said interlevel insulator layer including said molecular layer into a desired pattern; and

   a fifth step of forming a second-level metallization on said etched interlevel insulator layer.

2. The multilevel metallization forming method according to claim 1 wherein:

   said molecular layer is formed by means of a silylation.

3. The multilevel metallization forming method according to claim 1 wherein:

   said molecular layer is formed by a surface-active agent.

4. The multilevel metallization forming method according to claim 3 wherein:

   said surface-active agent contains silicon or germanium.

5. The multilevel metallization forming method according to claim 3 wherein:

   said surface-active agent is a silane compound, siloxane compound, disilazane compound, trisilazane compound, piperazine compound, amino germanium compound, or germanium halide compound.

6. The multilevel metallization forming method according to claim 1 further comprising:

   a step which is performed between said second and third steps, to remove water contained in said interlevel insulator layer by heating said semiconductor substrate including said interlevel insulating layer at temperatures below 500 °C.

7. The multilevel metallization forming method according to claim 1 wherein:

   said second step utilizes a CVD (chemical vapor deposition) process to deposit an organosilane-family material to form said interlevel insulator layer on said semiconductor substrate including said first-level metallization.

8. The multilevel metallization forming method according to claim 1 wherein:

   said second step utilizes a liquid application process to deposit a silanol-family material to form said interlevel insulator layer on said semiconductor substrate including said first-level metallization.

9. A multilevel metallization forming method comprising:

   a first step of forming a first-level metallization of aluminum or aluminum alloy on a semiconductor substrate;

   a second step of forming an interlevel insulator layer on said semiconductor substrate including said first-level metallization, at temperatures below 500 °C;

   a third step of etching said interlevel insulator layer into a desired pattern;

   a fourth step of forming a hydrophobic molecular layer on said etched interlevel insulator layer; and

   a fifth step of forming a second-level metallization on said molecular layer.

**10.** The multilevel metallization forming method according to claim 9 wherein:
said molecular layer is formed by means of a silylation.

**11.** The multilevel metallization forming method according to claim 9 wherein:
said molecular layer is formed by a surface-active agent.

**12.** The multilevel metallization forming method according to claim 11 wherein:
said surface-active agent contains silicon or germanium.

**13.** The multilevel metallization forming method according to claim 11 wherein:
said surface-active agent is a silane compound, siloxane compound, disilazane compound, trisilazane compound, piperazine compound, amino germanium compound, or germanium halide compound.

**14.** The multilevel metallization forming method according to claim 9 further comprising:
a step which is performed between said second and third steps, to remove water contained in said interlevel insulator layer by heating said semiconductor substrate including said interlevel insulator layer at temperatures below 500 °C.

**15.** The multilevel metallization forming method according to claim 9 further comprising:
a step which is performed between said third and fourth steps, to remove water contained in said interlevel insulator layer by heating said semiconductor substrate including said interlevel insulator layer at temperatures below 500 °C.

**16.** The multilevel metallization forming method according to claim 9 wherein:
said second step utilizes a CVD (chemical vapor deposition) process to deposit an organosilane-family material to form said interlevel insulator layer on said semiconductor substrate including said first-level metallization.

**17.** The multilevel metallization forming method according to claim 9 wherein:
said second step utilizes a liquid application process to deposit a silanol-family material to form said interlevel insulator layer on said semiconductor substrate including said first-level metallization.

**18.** A multilevel metallization forming method comprising:
a first step of forming a first-level metallization of aluminum or aluminum alloy on a semiconductor substrate;
a second step of forming an interlevel insulator layer on said semiconductor substrate including said first-level metallization at temperatures below 500 °C;
a third step of forming a first hydrophobic molecular layer on said interlevel insulator layer;
a fourth step of etching said interlevel insulator layer including said first molecular layer into a desired pattern;
a fifth step of forming a second hydrophobic molecular layer on said etched interlevel insulator layer; and
a sixth step of forming a second-level metallization on said second molecular layer.

**19.** The multilevel metallization forming method according to claim 18 wherein:
each said molecular layer is formed by a surface-active agent.

**20.** The multilevel metallization forming method according to claim 19 wherein:
said surface-active agent contains silicon or germanium.

**21.** The multilevel metallization forming method according to claim 19 wherein:
said surface-active agent is a silane compound, siloxane compound, disilazane compound, trisilazane compound, piperazine compound, amino germanium compound, or germanium halide compound.

**22.** The multilevel metallization forming method according to claim 18 wherein:
said second step utilizes a CVD (chemical vapor deposition) process to deposit an organosilane-family material to form said interlevel insulator layer on said semiconductor substrate including said first-level metallization.

23. The multilevel metallization forming method according to claim 18 wherein:
said second step utilizes a liquid application process to deposit a silanol-family material to form said interlevel insulator layer on said semiconductor substrate including said first-level metallization.

FIG.1

FIG.2 (a)

FIG.2 (b)

FIG.3

FIG.4 (a)

FIG.4 (b)

FIG.4 (c)

17

FIG.5(a)

FIG.5(b)

FIG.5(c)

FIG.5(d)

FIG.6(a)

FIG.6(b)

FIG.6(c)

F I G . 7

FIG.8(a)

FIG.8(b)

FIG.8(c)

FIG.8(d)

F I G.9 ( a )

F I G.9 ( b )

F I G.9 ( c )

FIG.10 (a)

FIG.10 (b)

FIG.10 (c)

FIG.10 (d)

FIG.11(a)

FIG.11(b)

FIG.11(c)

F I G .12

F I G.13

FIG.14

FIG.15(a)

FIG.15(b)

FIG.15(c)

FIG.15(d)

EP 0 678 913 A1

F I G.16 ( a )

F I G.16 ( b )

F I G.16 ( c )

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | WO-A-91 19317 (MITEL CORP) 12 December 1991<br>* page 1, line 20 - page 2, line 28 *<br>* page 9, line 20 - page 11, line 3 *<br>* page 11, line 31 - page 12, line 19 * | 1-6,8 | H01L21/768<br>H01L23/532 |
| A | | 9-14, 18-21,23 | |
| Y | EXTENDED ABSTRACTS,<br>vol. 90 - 1, 1 January 1990<br>pages 283-284, XP 000140870<br>RUCKER T ET AL 'CHEMICAL MODIFICATION OF SPIN-ON-GLASS FOR IMPROVED PROCESSING PERFORMANCE'<br>* page 283 * | 1-6,8 | |
| A | 1993 SYMPOSIUM ON VLSI TECHNOLOGY. DIGEST OF TECHNICAL PAPERS (IEEE CAT. NO.93CH 3303-5), PROCEEDINGS OF IEEE VLSI TECHNOLOGY SYMPOSIUM, KYOTO, JAPAN, 17-19 MAY 1993, 1993, TOKYO, JAPAN, BUS. CENTER FOR ACAD. SOC. JAPAN, JAPAN,<br>YANO K ET AL 'Improved interconnect yield through surface control by silylation (SCS) method'<br>* page 129, column 1, paragraph 1 - page 129, column 1, paragraph 3 *<br>* page 130; figure 3 * | 1-5, 9-13, 18-21 | |
| P,X | EP-A-0 643 421 (MATSUSHITA ELECTRIC IND CO LTD) 15 March 1995<br>* column 4, line 20 - line 39 *<br>* column 7, line 43 - column 8, line 9 *<br>* column 12, line 26 - line 33 * | 1-5,7 | |

TECHNICAL FIELDS SEARCHED (Int.Cl.6)

H01L

The present search report has been drawn up for all claims

| Place of search | Date of completion of the search | Examiner |
|---|---|---|
| THE HAGUE | 12 July 1995 | Schuermans, N |

EPO FORM 1503 03.82 (P04C01)